# EUROPÄISCHE PATENTSCHRIFT

(11) **EP 3 230 796 B1**
(45) Veröffentlichungstag und Bekanntmachung des Hinweises auf die Patenterteilung: **05.06.2019**
(21) Anmeldenummer: 15817054.8
(22) Anmeldetag: 09.12.2015
(51) Int. Cl.: G03F 7/00, G03F 7/004, G03F 7/027, G03F 7/028, G03F 7/029, G03F 7/031, G03F 7/075

(54) **POLY- BZW. PRÄPOLYMERZUSAMMENSETZUNG BZW. PRÄGELACK, UMFASSEND EINE DERARTIGE ZUSAMMENSETZUNG UND VERWENDUNG DESSELBEN**
POLY- OR PREPOLYMER COMPOSITION, OR EMBOSSING LACQUER COMPRISING SUCH A COMPOSITION AND USE THEREOF
COMPOSITION POLYMÈRE OU PRÉPOLYMÈRE OU PEINTURE D'IMPRESSION EN RELIEF COMPRENANT UNE TELLE COMPOSITION ET SON UTILISATION

(30) Priorität: 10.12.2014 AT 8882014
(43) Veröffentlichungstag der Anmeldung: 18.10.2017
(73) Patentinhaber: Joanneum Research Forschungsgesellschaft mbH, 8010 Graz (AT)
(72) Erfinder: NEES, Dieter, 8160 Thannhausen (AT); LEITGEB, Markus, 8350 Fehring (AT); STADLOBER, Barbara, 8044 Graz (AT); RUTTLOFF, Stephan, 8160 Weiz (AT); LINTSCHNIG, André, 8010 Graz (AT); SATZINGER, Valentin, 8010 Graz (AT)
(74) Vertreter: Strehl Schübel-Hopf & Partner
(86) Internationale Anmeldenummer: PCT/AT2015/000157
(87) Internationale Veröffentlichungsnummer: WO 2016/090395

(56) Entgegenhaltungen:
- EP-A1- 2 286 980
- WO-A1-2011/145716
- WO-A1-2013/002734
- GB-A- 2 003 494
- GB-A- 2 089 581
- US-A1- 2010 109 317

## Beschreibung

Die vorliegende Erfindung bezieht sich auf eine Präpolymerzusammensetzung enthaltend wenigstens einen Mono- oder Oligomerbaustein mit wenigstens einer polymerisierbaren Doppelbindung sowie wenigstens einen multifunktionalen Monomerbaustein sowie auf eine Verwendung derselben.

Durch den rasanten Aufschwung der Nanotechnologie in den letzten Jahren gewinnt die Herstellung von nanostrukturierten Komponenten in der industriellen Fertigung zusehends an Bedeutung, wobei derartige nanostrukturierte Komponenten üblicherweise aus fotopolymerisierbaren Präpolymerzusammensetzungen hergestellt werden. Insbesondere in der Sicherheitstechnik, dem Dekorbereich, dem Produktmarketing, der Oberflächenveredelung verschiedenster Werkstoffe und anderen Gebieten werden zunehmend feinste Strukturen eingesetzt, um bestimmte zusätzliche Funktionen zu erzielen, wie beispielsweise eine Selbstreinigung von Oberflächen oder auch um dekorative optische Effekte hervorzurufen oder eine Antireflexion und dgl. Hierfür werden nanotechnologisch aufbereitete Strukturen, welche aus speziellen Präpolymerzusammensetzungen gefertigt sind, eingesetzt. Ein noch bedeutender Einsatzzweck von derartigen mikro- und nanostrukturierten Folien ist bei elektronischen, optischen, sensorischen und magnetischen Bauelementen, wie integrierten Schaltkreisen, Displays, Mikrooptiken und dgl., da kleine Strukturgrößen für die Funktionalität dieser Elemente der entscheidende Faktor sind, und es existieren daher intensive Bemühungen auf dem Gebiet der großflächig gedruckten Elektronik, Bauelemente auf Foliensubstraten zu fertigen. Für die industrielle Folienfertigung spielen daher Mikro- und Nanostrukturierungstechniken, wie Rolle-zu-Rolle, Rolle-zu-Platte oder Blatt-zu-Blatt Imprinttechnologien eine wichtige Rolle und erfordern immer neue und verbesserte abformbare Folien oder Zusammensetzungen, aus welchen derart strukturierte Folien herstellbar sind.

Die industrielle Folienveredelung umfasst einen sehr großen Bereich, der von der Verbesserung der mechanischen oder dekorativen Oberflächeneigenschaften bis zur Integration von optischen, sensorischen und elektronischen Funktionalitäten in der Werkstofffolie reicht. Insbesondere die Rolle-zu-Rolle (R2R), Rolle-zu-Platte (R2P) und Blatt-zu-Blatt (S2S) Fertigungsprozesse erlauben wegen der kontinuierlichen Produktionsweise und der großen erzielbaren Folienformate eine hohe Produktionsgeschwindigkeit und einen hohen Durchsatz, wodurch die Kosten gesenkt werden können und größere Produktmengen zur Verfügung gestellt werden können. Ein entscheidendes Kriterium und gleichzeitig eine limitierende Komponente für den Einsatz derartiger Produktionstechniken ist allerdings das Faktum, dass Produkte häufig Strukturen mit Dimensionen im unteren Mikrometer- oder Nanometerbereich aufweisen, einerseits wegen der hohen Integrationsdichte ihrer Einzelkomponenten, aber auch, um die Funktionalität der Strukturen in der Größenordnung der verwendeten Wellenlänge zu gewährleisten und die Oberflächen insgesamt zu vergrößern. Herkömmliche Massendruckverfahren, wie Tiefdruck, Flexodruck, Siebdruck, Offsetdruck und dgl. erlauben zwar einen extrem hohen Durchsatz von mehreren 100 m pro Minute, schaffen es jedoch üblicherweise nicht, den notwendigen strukturellen Auflösungsbereich zur Verfügung zu stellen. Die einzige derzeit bekannte Technik, die es ermöglicht, Strukturen mit minimalen Dimensionen im Nanometerbereich in einem parallelen Verfahren herzustellen, ist die sogenannte Nanoimprintlithographie (NIL), welche ein hoch präzises Prägeverfahren darstellt und mit welchem es möglich ist, auch kleinste Strukturen auf dem entsprechenden Substrat auszuformen.

Rolle-zu-Rolle Nanoimprintlithographieverfahren werden industriell bis dato vor allem zur Erzeugung von Prägehologrammen, beispielsweise als Fälschungsschutz bei Banknoten eingesetzt. Hierfür werden in dem Nanoimprintlithographieverfahren ähnliche Prozesse verwendet, allerdings bestehen die geprägten Strukturen aus Beugungsgittern, wobei ein oberflächliches Relief entsteht. Rolle-zu-Rolle Nanoimprintlithographieverfahren werden neuerdings vor allem in kontinuierlichen Verfahren eingesetzt, wobei der notwendige Prägedruck durch Folienzug und Anpressdruck der Gegenwalze gewährleistet wird. Entscheidend bei derartigen Verfahren ist, dass ein Anhaften des Lacks am Prägewerkzeug vermieden wird, um nachfolgend eine defektfreie Entformung des geprägten Gegenstands erzielen zu können. Für ein Rolle-zu-Rolle Nanoimprintverfahren werden gegenwärtig zwei verschiedene Arten von Prägewerkzeugen verwendet, und zwar kann entweder das Prägeprofil direkt auf einer Prägewalze erzeugt werden, oder auf einem dünnen flexiblen Blech oder Folienmaterial, welches anschließend um eine Walze festgelegt wird. Gegenwärtig werden als derartige, um eine Walze anordenbare Metallfolien, sogenannte Shims, aus Nickel eingesetzt, wobei die Fertigung von derartigen Nickelshims relativ kompliziert ist. Es gibt daher Bestrebungen, die Nickelshims durch Prägestempel aus Polymermaterialien zu ersetzen, wobei Polymermaterialien potentiell niedrigere Oberflächenenergien als Nickel aufweisen, was die Lackanhaftung beim Prägeprozess verringert. Überdies sind die Herstellungskosten von Polymerprägestempeln bedeutend niedriger, allerdings haben sie den Nachteil, dass sie üblicherweise relativ leicht deformierbar sind, so dass sie als Prägestempel im Submikrometerbereich nur sehr begrenzt eingesetzt werden können. Ein weiterer Nachteil von in radikalischen Kettenreaktionen vernetzenden Polymermaterialien im Prägeverfahren ist darin begründet, dass geeignete Materialien üblicherweise nur unter Sauerstoffausschluss vollständig vernetzt werden können, was in einem Rollenverfahren problematisch erscheint, da sie nicht schnell genug ausreichen aushärten, um bei einem Rollenimprintverfahren eingesetzt zu werden, und somit ihre Prägetreue relativ gering ist, und sie überdies aufgrund des üblicherweise hohen enthaltenen Gewichtsanteils von Urethanacrylat-Oligomeren einem langsamen Aushärteprozess unterliegen, so dass eine defektfreie Selbstreplikation des Stempels in einem Rollenverfahren nicht möglich erscheint. Für eine R2R-Prägung ist jedoch die vollständige Umsetzung der reaktiven C-C-Doppelbindungen im Polymer-Stempelmaterial vor der R2R-Prägung vor allem deshalb notwendig, weil diese sonst mit den C-C-Doppelbindungen im Prägelack reagieren, was zwangsläufig zum Verkleben von Stempel und Lack führt.

Aus der WO 2009/148138 A1 ist bereits eine Form bestehend aus einem geformten Harz ebenso wie ein Verfahren zur Herstellung desselben bekannt geworden, mit welchem robuste und gleichzeitig feine Strukturen auf einer Oberfläche ausgebildet werden können. Eine für die Ausbildung der Form einsetzbare photohärtbare Harzzusammensetzung enthält einen Polymerisationsindikator ebenso wie ein entsprechendes photopolymerisierbares Monomer.

Die vorliegende Erfindung zielt nun darauf ab, eine Präpolymerzusammensetzung zu Verfügung stellen, mit welcher es gelingt, sowohl daraus herstellbare Prägelacke als auch Polymerprägewerkzeuge für die Rolle-zu-Rolle Nanoimprintlithographie auszubilden, mit welchen es gelingt, nicht nur Strukturen im Subnanometerbereich sicher und zuverlässig auf der aus dem Präpolymer gebildeten Folienoberfläche auszubilden, sondern diese in einer Vielzahl von Malen abzudrucken oder zu replizieren und insbesondere ohne gesondertes Aufbringen eines Releasematerials auf das Prägewerkzeug zu replizieren und abzudrucken.

Zur Lösung dieser Aufgabe ist eine erfindungsgemäße Präpolymerzusammensetzung im Wesentlichen dadurch gekennzeichnet, dass der multifunktionale Monomerbaustein ein multifunktionaler Monomerbaustein mit wenigstens zwei Thiol-Gruppen gewählt aus der Gruppe: 3-Mercaptopropionate, 3-Mercaptoacetate, Thioglycolate und Alkylthiole, entält, dass der Mono- oder Oligomerbaustein mit wenigstens einer polymerisierbaren Doppelbindung aus der Gruppe der Acrylate, Methylacrylate, Vinylether, Allylether, Propenylether, Alkene, Diene, ungesättigten Ester, Allyl-Triazine, Allyl-Isocyanate und N-Vinylamide gewählt ist und dass wenigstens ein oberflächenaktives Antihaftadditiv gewählt aus der Gruppe Alkyl-(Meth-)Acrylate, Poly-Siloxan-(Meth-)Acrylate, Perfluoralkyl-(Meth-)Acrylate, Perfluorpolyether-(Meth-)Acrylate, Alkylvinylether, Poly-Siloxan-Vinylether, Perfluoralkyl-Vinylether und Perfluorpolyether-Vinylether sowie ein Photoinitiator enthalten sind.

Indem gemäß der Erfindung der Mono- oder Oligomerbaustein mit wenigstens einer polymerisierbaren Doppelbindung gewählt aus der Gruppe der Acrylate, Methacrylate, Vinylether, Allylether, Propenylether, Alkene, Diene, ungesättigten Ester, Allyl-Triazine, Allyl-Isocyanate und N-Vinylamide gewählt ist, erfolgt eine rasche Reaktion mit radikalischen Sauerstoffmolekülen bei einer durch den Photoinitiator initiierten radikalischen Polymerisation. Die bei einer derartigen Reaktion entstehenden Peroxyradikale sind sehr reaktionsträge und reagieren nicht mit Kohlenstoff-Kohlenstoff-Doppelbindungen. Aus diesem Grund führt bei der radikalischen Polymerisation jedes Sauerstoffmolekül zum Abbruch einer Polymerisationskettenreaktion, was nicht wünschenswert ist. Bei Anwesenheit von einem multifunktionalen Monomerbaustein mit wenigstens zwei Thiol-Gruppen abstrahieren die Peroxyradikale jedoch Wasserstoff-Atome von den Thiol-Gruppen unter Bildung von Thionylradikalen, die sich wiederum an die Kohlenstoff-Kohlenstoff-Doppelbindungen addieren und eine Polyadditionsreaktion starten. Die durch die Thiole induzierte Polyaddition führt so die UV-Vernetzung weiter. Durch das gleichzeitige Wachstum vieler Reaktionszentren kommt es erst bei sehr hohen Umsätzen zu einer Gelierung, z.B. im Vergleich zu reinen Acrylatsystemen, wodurch die wachsenden Moleküle länger beweglich bleiben, was insgesamt zu höheren Polymerisationsgeschwindigkeiten und höheren Umsatzraten führt. Gleichzeitig werden durch die Erzeugung vieler Reaktionszentren eine gleichmäßigere Vernetzung und geringere Spannungen innerhalb des Polymerisats erreicht, ebenso wie eine stark verringerte Schrumpfung des Materials bei der Verfestigung.

Für die Durchführung der Polymerisation ist es neben dem Vorhandensein eines Photoinitiators günstig, zusätzlich wenigstens einen Mono- oder Oligormerbaustein mit wenigstens einer polymerisierbaren Doppelbindung einzusetzen, welcher aus der Gruppe der Acrylate, Methacrylate, Vinylether, Allylether, Propylether, Alkene, Diene, ungesättigte Ester, Allyltriazine, Allylisocyanate und N-Vinylamide gewählt ist, sowie ein oberflächenaktives Antihaftadditiv zuzusetzen, um dadurch die Adhäsionsenergie, d.h. die Haftung zwischen dem aus der Präpolymerzusammensetzung gebildeten Prägelack und dem Shim oder Stempel zu verringern, was eine rückstandsfreie Ablösung der zwei Materialien ermöglicht.

Indem, wie dies einer Weiterbildung der Erfindung entspricht, die Präpolymerzusammensetzung so weitergebildet ist, das der multifunktionale Monomerbaustein mit wenigstens zwei Thiolgruppen in einer Menge von 1 Gew.-% bis 50 Gew.-%, insbesondere von 5 Gew.-% bis 30 Gew.-% enthalten ist, und dass zwei der wenigstens eine polymerisierbare Doppelbindung aufweisenden Mono- oder Oligomerbausteine in einer Gesamtmenge von 1 Gew.-% bis 90 Gew.-%, insbesondere von 10 Gew.-% bis 50 Gew.-% enthalten sind, wird einerseits durch gezielten Einsatz der Menge des wenigstens zwei Thiolgruppen aufweisenden multifunktionalen Monomerbausteins die bei jeder Polymerisation auftretende Schrumpfung bereits im flüssigen Zustand bewirkt, wodurch in einem nachfolgenden UV-Prägeprozess die Abformtreue gegenüber herkömmlichen Materialien deutlich verbessert ist. Im Einzelnen weisen daher die Präpolymerzusammensetzungen gemäß der Erfindung im vollständig vernetzten Zustand eine deutlich verringerte Schrumpfung gegenüber herkömmlichen Polymeren auf.

Indem weiterhin zwei der wenigstens eine polymerisierbare Doppelbindung aufweisenden Mono- oder Oligomerbausteine in einer Gesamtmenge von 1 Gew.-% bis 90 Gew.-%, insbesondere von 10 Gew.-% bis 50 Gew.-% enthalten sind, kann die Polymerisationsgeschwindigkeit gezielt gesteuert werden. Die zwei eingesetzten wenigstens eine polymerisierbare Doppelbindung aufweisenden Mono- oder Oligomerbausteine unterscheiden sich hierbei insbesondere in ihrem Molekulargewicht. Beispielsweise kann einer der zwei wenigstens eine polymerisierbare Doppelbindung aufweisenden Mono- oder Oligomerbausteine ein reaktives Monomer und der andere ein Oligomerbaustein sein, wodurch sich die Materialeigenschaften eines daraus hergestellten ausgehärteten Polymers gezielt einstellen lassen. So führt eine Erhöhung des Anteils von einem der zwei eine polymerisierbare Doppelbindung aufweisenden Mono- oder Oligomerbausteine zu einer Erniedrigung der Polymerisationsgeschwindigkeit aufgrund der verringerten Beweglichkeit oder Flexibilität der Mono-oder Oligomerbausteine. Eine Verlängerung von Seitenketten führt demgegenüber wegen der höheren Beweglichkeit und Flexibilität der Mono- oder Oligomerbausteine zu einer signifikanten Erhöhung der Polymerisationsgeschwindigkeit und somit zu erhöhten Umsätzen. Durch gezielte Wahl der eingesetzten Menge der zwei Hauptbestandteile der Präpolymerzusammensetzung kann somit beispielsweise eine Polymerzusammensetzung, wie ein Prägelack gebildet werden, welcher eine extrem hohe Abformtreue bei gleichzeitig verringerter Schrumpfung und großer Stabilität aufweist.

Indem, wie dies einer Weiterbildung der Erfindung entspricht, als Mono- oder Oligomerbaustein mit wenigstens einer polymerisierbaren Doppelbindung Urethanacrylat-Oligomere mit einem Molekulargewicht zwischen etwa 300 g/mol und 2500 g/mol einsetzt sind, gelingt es, gezielt eine Präpolymerzusammensetzung zur Verfügung zu stellen, welche bei einem nachfolgenden Auftragen oder Aufbringen der Polymerschicht im Vergleich zu herkömmlichen Schichten eine gleichmäßige Schichtdicke erreichen lässt, welche frei von Unregelmäßigkeiten ist. Diese Präpolymerzusammensetzung weist leicht verarbeitbare Viskositäten auf. Im Einzelnen haben z.B. Urethanacrylat-Oligomere oder Polyester-Oligomere eine hohe Viskosität und derartige Viskositäten erschweren oder verhindern das gleichmäßige Auftragen einer dünnen Schicht der Präpolymerzusammensetzung mittels Tiefdruck oder anderen Beschichtungsverfahren, wie Inkjet und Slit Coating. Um sicherzustellen, dass einerseits die Viskosität nicht zu hoch wird und andererseits die Schichtdicken nicht zu groß werden oder insbesondere unregelmäßig werden, wird daher gemäß der Erfindung so vorgegangen, dass zu den Urethanacrylat-Oligomeren mit einem höheren Molekulargewicht z. B. Acrylat-Monomere oder Vinylester-Monomere als sogenannte reaktive Verdünner zugesetzt werden, um gleichmäßige Schichtdicken zu erreichen und insbesondere die Viskosität nicht zu stark anzuheben.

Gemäß einer Weiterbildung der Erfindung hat es sich hierbei als vorteilhaft erwiesen, um die Viskosität der Präpolymerzusammensetzung möglichst gering zu halten und um ein gleichmäßiges Auftragen von dünnen Schichten zu ermöglichen, so vorzugehen, dass die Mono- oder Oligomerbausteine mit wenigstens einer polymerisierbaren Doppelbindung aus der Gruppe der bifunktionalen Urethanacrylat-Oligomere mit einem Molekulargewicht zwischen 300 g/mol und 1200 g/mol, trifunktionalen Urethanacrylat-Oligomere mit einem Molekulargewicht zwischen 450 g/mol und 1750 g/mol und tetrafunktionellen Urethanacrylat-Oligomere mit einem Molekulargewicht zwischen etwa 500 g/mol und 2500 g/mol gewählt sind. Durch eine derartige Wahl der Molekulargewichte in Abhängigkeit von der Funktionalität des Urethanacrylat-Oligomers gelingt es unter anderem, das hinreichend schnelle Fließen des Präpolymers in die Stempeltopographie sicherzustellen, wodurch insbesondere auch extrem kleine Strukturen sicher und zuverlässig abgeformt werden können.

Indem, wie dies einer Weiterbildung der Erfindung entspricht, das oberflächenaktive Antihaftadditiv eine Menge von 0,01 Gew.-% bis 10 Gew.-%, insbesondere 0,1 Gew.-% bis 3 Gew.-% enthält, wird sichergestellt, dass die Oberflächenenergie der Präpolymerzusammensetzung soweit herabgesetzt ist, dass wiederholt defektfrei weitere Generationen von Mustern durch Prägen oder Abformen gezogen werden können. Die Oberflächenenergie von derartigen Prägelacken wird hierbei nicht unwesentlich von der Oberflächenenergie der angrenzenden Phase beeinflusst, wobei gilt, je niedriger die Oberflächenenergie der angrenzenden Phase ist, desto niedriger ist auch die Oberflächenenergie eines aus der Präpolymerzusammensetzung geprägten Polymers und desto besser sind die Antihafteigenschaften derselben. Eine derartig niedrige Oberflächenenergie des Prägemasters pflanzt sich in einem so ausgebildeten Prägestempel fort und kann auch über mehrere Abformungen aufrechterhalten werden.

Indem, wie dies einer Weiterbildung der Erfindung entspricht, der in der Präpolymerzusammensetzung enthaltene Photoinitiator aus der Gruppe der Thioxanthone, Ketosulphone, (Alkyl-)-Benzoyl-Phenyl-Phosphinoxide, 1-Hydroxyalkylphenylketone oder 2,2Dimethoxy-1,2-diphenylethan-1-on gewählt ist, gelingt es, die Polymerisation effektiv zu initiieren.

Indem, wie dies einer Weiterbildung der Erfindung entspricht, der Photoinitiator in einer Menge von 0,1 Gew.-% bis 10 Gew.-%, insbesondere 0,5 Gew.-% bis 5 Gew.-% enthalten ist, kann die Polymerisationsgeschwindigkeit der Zusammensetzung gezielt gesteuert werden. Allgemein ist festzuhalten, dass, je höher die Konzentration des Photoinitialtors ist, desto größer ist die Polymerisationsgeschwindigkeit in den verwendeten dünnen Schichten, so dass sich insbesondere eine Menge im unteren Bereich von 0,5 Gew.-% bis 5 Gew.-% des Photoinitiators für eine Polymerisation gemäß der Erfindung als vorteilhaft erwiesen hat.

Je höher der Massenanteil an beispielsweise einem Urethanacrylat-Oligomeren ist, desto größer ist die Härte der endgültigen polymeren Zusammensetzung, und daher zeigt es sich, dass es im Rahmen der vorliegenden Erfindung häufig erforderlich ist, insbesondere zur Einstellung von beispielsweise der Viskosität, dem Elastizitätsmodul, der Indentationshärte und dgl. einen reaktiven Verdünner zuzusetzen, wobei, wie dies gemäß der Erfindung bevorzugt ist, der reaktive Verdünner aus der Gruppe der aliphatischen (Meth-)Acrylate oder Polyether(meth-)acrylate, insbesondere HDDA, PEODA oder TMP(EO)xTA gewählt ist. Hierbei hat es sich herausgestellt, dass die Armlänge des Verdünners einen wesentlichen Einfluss auf die Härte der Polymerzusammensetzung besitzt. Mit steigendem Anteil an reaktivem Verdünner und insbesondere dadurch, dass als reaktiver Verdünner wenigstens ein multifunktionales aliphatisches oder Polyether(meth-)acrylat, insbesondere TMP(EO)₉TA, TMP(EO)₆TA, TMP(EO)₃TA oder TMPTA enthalten ist, kann hierbei neben der Viskosität der Präpolymerzusammensetzung auch die Härte der Polymerzusammensetzung gezielt beeinflusst werden. Hierbei führt beispielsweise der Einsatz von TMP(EO)₉TA zu einer starken Herabsetzung der Härte der Polymerzusammensetzung, wohingegen der Einsatz von TMP(EO)₃TA zu einer deutlich geringeren Herabsetzung der Härte der Polymerzusammensetzung führt, so dass durch gezielte Auswahl des reaktiven Verdünners die Härte des Endprodukts gezielt gesteuert werden kann.

Bei der mit dem Nicht-Nomenklaturnamen "Trithiol" bezeichneten Verbindung handelt es sich um Trimethylolpropantris-(3-mercaptoproprionat).

Indem, wie dies einer Weiterbildung der Erfindung entspricht, die Präpolymerzusammensetzung eine Viskosität von 0,01 Pas bis 1 Pas aufweist, wird eine gute Fließfähigkeit der Präpolymerzusammensetzung erreicht, so dass nicht nur ein gleichmäßiges Beschichten von abzuformenden Oberflächen erreicht wird, sondern auch sichergestellt wird, dass die Präpolymerzusammensetzung ausreichend schnell fließt, um auch die Vertiefungen von sehr feinen Mustern ausreichend rasch und vollständig auszufüllen.

Um insbesondere ein Anhaften der Präpolymerzusammensetzung an Oberflächen, wie beispielsweise einer Nickelshim-Oberfläche so gering wie möglich zu halten oder ganz hintanzuhalten, ist die Erfindung dahingehend weitergebildet, dass zusätzlich ein silikonhaltiges oder fluorhaltiges Additiv, gewählt aus der Gruppe der mono- oder polyfunktionalen Polydimethylsiloxan-(meth-)-acrylate, Perfluor-n-alkyl-(meth-)-acrylate oder Perfluorpolyether-(meth)-acrylate in einer Menge von 0,1 Gew.-%bis 3 Gew.-% als oberflächenaktive Antihaftadditiv enthalten ist. Silikonhaltige oder fluorhaltige Additive tragen zur Verringerung der Adhäsion und zur Erleichterung der Ablösung der aus der Präpolymerzusammensetzung gebildeten Polymerzusammensetzungen von dem Prägewerkzeug bei, wobei sich insbesondere die perfluorierten Additive als besonders günstig erwiesen haben und eine Mehrzahl von Abformungen eines Musters zuverlässig ermöglichen.

Die Erfindung zielt weiterhin auf die Verwendung der Präpolymerzusammensetzung gemäß der Erfindung zur Ausbildung eines Prägelacks ab. Derartige Prägelacke sind zum Einsatz in Rolle-zu-Rolle-, Rolle-zu-Platte- oder Blatt-zu-Blatt-Verfahren besonders gut geeignet und zeigen exzellente Abformungseigenschaften, so dass eine Verwendung derselben im industriellen Maßstab gelingt. Eine besonders hohe Zahl von Zyklen in einem Prägeverfahren kann gemäß der Erfindung durch die Verwendung der Präpolymerzusammensetzung erreicht werden, welche dadurch gekennzeichnet ist, dass die gehärtete Präpolymerzusammensetzung einen Elastizitätsmodul zwischen 50 MPa und 5 GPa und eine Oberflächenenergie von 10 bis 60 mJ/cm² aufweist. Prägelacke, welche einen Elastizitätsmodul zwischen 50 MPa und 5 GPa aufweisen, sind hinreichend fest sowie ausreichend flexibel und zeigen hinreichend niedrige Adhäsionsenergien, um wiederholt abgeformt zu werden, ohne dass eine Beeinträchtigung, insbesondere ein Verzerren, des Musters zu befürchten ist. Aufgrund der möglichen extrem niedrigen Oberflächenenergie und damit Adhäsionsenergie gelingt es weiterhin, damit mehrere Generationen von Prägungen und Abformungen durchzuführen, ohne dass Beschädigungen durch anhaftenden Prägelack auftreten.

Schließlich zielt die Erfindung auf eine Verwendung der Präpolymerzusammensetzung zur kontinuierlichen Strukturierung und in situ UV-Härtung in einem Rolle-zu-Rolle Imprintverfahren ab, sowie zur Herstellung von selbstabformungsfähigen Prägestempeln zur UV-Prägung von im Wesentlichen gleichartigen Polymeren. Auch wenn vergleichbare Präpolymerzusammensetzungen auf anderen technischen Gebieten gegebenenfalls schon zum Einsatz gelangt sind, konnte überraschenderweise gezeigt werden, dass aus einer Präpolymerzusammensetzung in situ Prägelacke für ein Rolle-zu-Rolle-Imprintverfahren gebildet werden können, mit welchen eine Mehrzahl von Abformungen ohne Beschädigung des zu druckenden Musters und insbesondere getreue Abformungen von nanostrukturierten Topographien erreicht werden können.

Weiterhin gelingt es, wie dies einer Weiterbildung der Erfindung entspricht, die Präpolymerzusammensetzung als selbstabformungsfähigen Prägestempel zur Vorprägung von im Wesentlichen gleichartigen Prägelacken heranzuziehen.

Die Erfindung wird nachfolgend anhand von Ausführungsbeispielen sowie Zeichnungen näher erläutert. In diesen zeigen
Fig. 1 ein Diagramm, welches den Einfluss der Menge des multifunktionalen Monomerbausteins mit wenigstens zwei Thiolgruppen auf die Umsetzung der C-C-Doppelbindungen in Abhängigkeit von der Zeit bei Aushärtung der Präpolymerzusammensetzung durch UV-Bestrahlung zeigt,
Fig. 2 ein analoges Diagramm wie in Fig. 1, welches den Einfluss der Menge des Mono-oder Oligomerbausteins auf die Umsetzung der C-C-Doppelbindungen in Abhängigkeit von der Zeit bei Aushärtung der Präpolymerzusammensetzung durch UV-Bestrahlung zeigt,
Fig. 3 ein Diagramm, welches den Einfluss der einzelnen Komponenten des Präpolymers auf die dynamische Viskosität des Präpolymers zeigt,
Fig. 4 ein Diagramm, welches den Verlauf des Elastizitätsmoduls in Abhängigkeit von der Konzentration der Einzelbestandteile des Präpolymers zeigt,
Fig. 5 die Änderung der Oberflächenenergie der Präpolymerzusammensetzung in Abhängigkeit von der Menge des eingesetzten Antihaftadditives, und

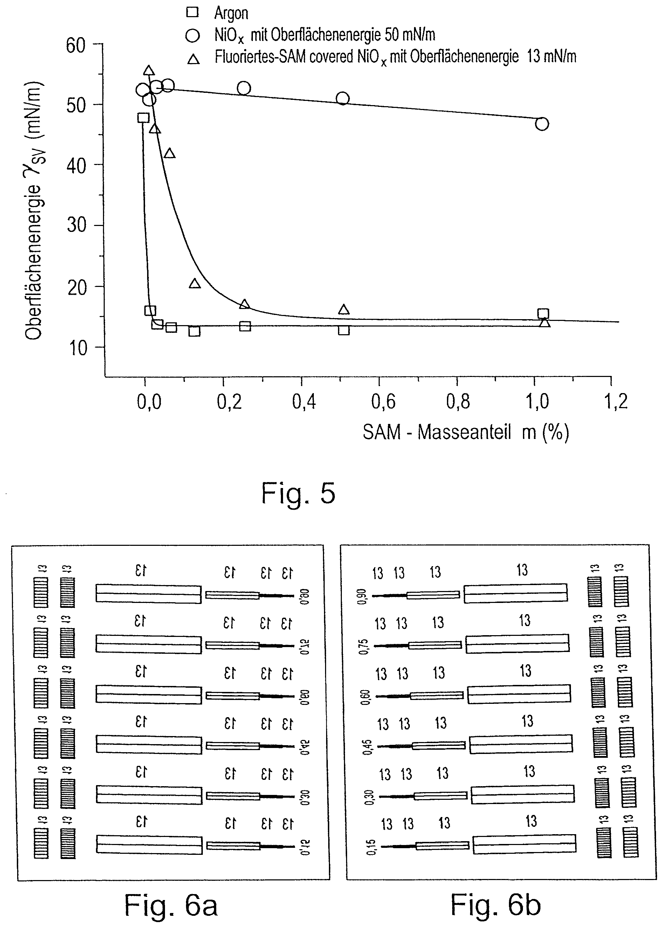

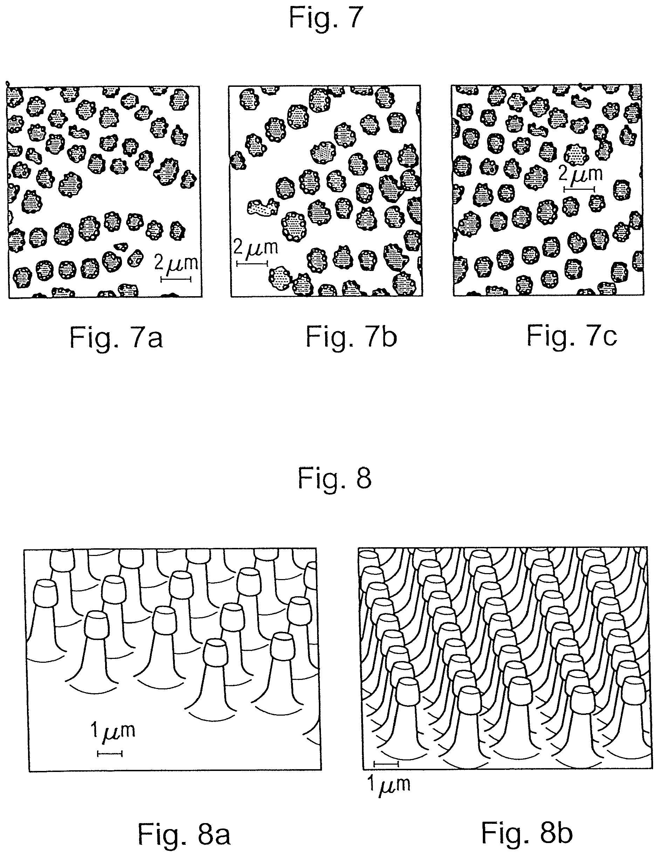

Fig. 6, 7 und 8 Beispiele für die Selbstreplizierbarkeit von Prägelacken, die auf Basis der Präpolymerzusammensetzung gemäß der Erfindung hergestellt wurden, wobei Fig. 6 einen von einem Nickelmaster abgeformten Urethanacrylat-Polymerstempel (Fig. 6a) und eine damit durchgeführte Polymerprägung (Fig. 6b) zeigt, Fig. 7 eine analoge Darstellung, in welcher Fig. 7a einen Urethanacrylat-Master zeigt, Fig. 7b den davon abgeformten Urethanacrylat-Prägestempel auf Folie zeigt, und Fig. 7c die mit der Folie hergestellte Prägung in einem Urethanacrylat- Prägelack auf einer Folie zeigt, und Fig. 8 ein Beispiel der Übertragung von dreidimensionalen Strukturen mit einem Urethanacrylat- Prägestempel gemäß der Erfindung zeigt, wobei Fig. 8a den Silizium-Prägemaster zeigt und Fig. 8b die mittels eines Urethanacrylat-Polymer-Rollenstempels im Rolle-zu-Rolle UV-Imprintverfahren hergestellte Prägung auf Folie zeigt.

Beispiel 1 zeigt den Einfluss der Zugabe eines multifunktionalen Monomerbausteins mit mindestens zwei Thiolgruppen auf die Polymerisationskinetik.

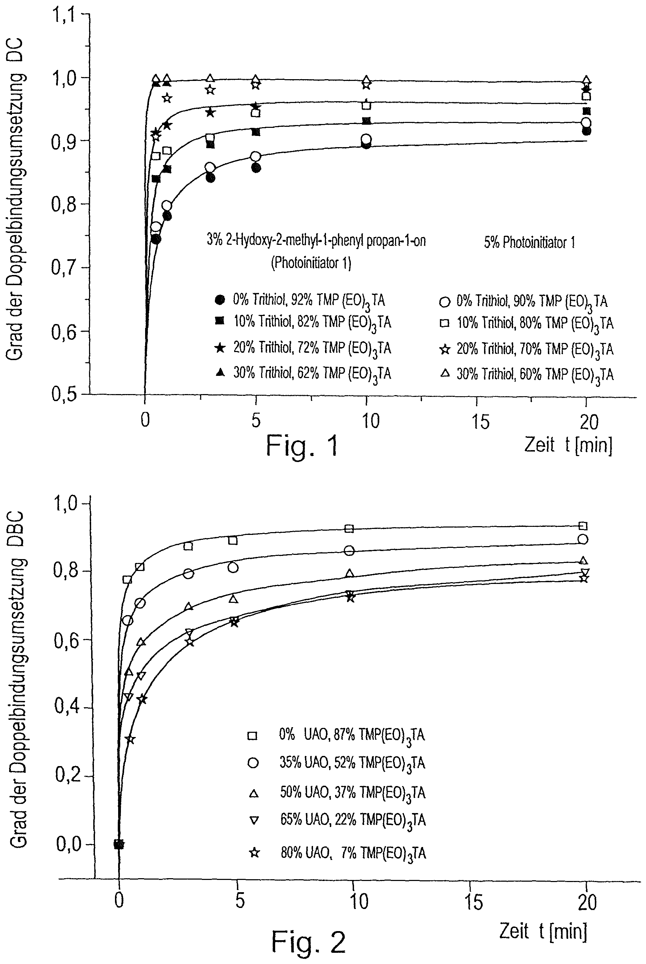

Im Einzelnen wurden variierende Mengen an Trithiol (Trimethylolpropantris(3mercaptopropionat)), jeweils einer Präpolymermatrix enthaltend 4,5 % tetrafunktionelles Urethanacrylat-Oligomer (UAO), 0,5 % Antihaftadditiv, Polydimethylsiloxan, 3 % bzw. 5 % eines Photoinitiators, nämlich 2-Hydroxy-2-methyl-1-phenyl-propan-1-on sowie ein reaktiver Verdünner TMP(EO)₃TA zugesetzt. Mit steigendem Trithiolanteil wird der Gehalt an reaktivem Verdünner TMP(EO)₃TA in gleichem Ausmaß reduziert. Wie aus Fig. 1 klar ersichtlich ist, wird die Reaktionskinetik deutlich beschleunigt, je höher der Anteil an Trithiol ist. Aus Fig. 1 ist weiterhin erkenntlich, dass, je höher der Gehalt an Trithiol ist, desto höher ist der Gehalt an umgesetzten Doppelbindungen. Aus Fig. 1 ist schließlich ersichtlich, dass bei einem 30 %-igen Trithiolgehalt bereits nach wenigen Sekunden eine vollständige Umsetzung sämtlicher C-C-Doppelbindungen stattgefunden hat, und dass eine Erhöhung des Photoinitiatoranteils von 3 % auf 5 % ebenfalls zu einer Beschleunigung der Polymerisation führt.

Es folgt daraus, dass, je höher die Anteile an Trithiol, bzw. Anteile an multifunktionalen Monomerbausteinen, die wenigstens zwei Thiolgruppen aufweisen, in der Präpolymerzusammensetzung sind, desto schneller ist die vollständige Umsetzung der C-C-Doppelbindung, wobei derartige Präpolymerzusammensetzungen beispielsweise als Prägelacke (Imprintlacke) verwendbar sind. Ein nicht vollständiger Umsatz der C-C-Doppelbindungen in der kurzen zur Verfügung stehenden Belichtungszeit von < 1s, mit z.B. 2 W/m² in einem R2R Prägeprozess würde zu einer klebenden Oberfläche führen, wodurch eine Trennung des Lacks vom Stempel nicht möglich erscheint und es beispielsweise zu Lackanhaftungen auf dem Stempel kommen kann. Der Zusatz von multifunktionalen Monomerbausteinen mit wenigstens zwei Thiolgruppen erlaubt eine derart schnelle Umsetzung der C-C-Doppelbindungen, dass die Prägelacke in einem kontinuierlichen Rolle-zu-Rolle-UV-Nanoimprintlithographieprozess eingesetzt werden können. Eine Erhöhung des Urethanoligomer-Acrylatanteils in einer Präpolymermatrix aus 9,5 % Trithiol, 0,5 % Polydimethylsiloxan als Antihaftadditiv, 3 % 2-Hydroxy-2-methyl-1-phenyl-propan-1-on als Photoinitiator und TMP(EO)₃TA als restreaktiven Verdünner führt zu einer Entschleunigung der Polymerisationskinetik, wie dies in Fig. 2 erkennbar ist. Je höher der Anteil an dem Urethanacrylat-Oligomer, (d.h. dem Mono- oder Oligomerbaustein mit wenigstens einer polymerisierbaren Doppelbindung ist,) desto langsamer wird die Polymerisationskinetik, was mit einer Erhöhung der Viskosität und somit einer Verringerung der Mobilität der Radikale erklärbar ist. Die Folge davon ist eine schnellere Erreichung des Gelpunkts, eine niedrigere Umsetzungsrate und letztlich ein niedrigerer Umsatzgrad. Aus Fig. 1 und 2 ist ersichtlich, dass für den Einsatz als Imprintlacke eine Präpolymerzusammensetzung einen möglichst hohen Gehalt an multifunktionalen Monomerbausteinen mit wenigstens zwei Thiolgruppen aufwiesen muss. Beispielhaft ist hierbei die folgende Präpolymerzusammensetzung genannt: 20 % Trithiol, 35 % < x < 60 % UAO, (74,5-x)% TMP(EO)₃TA, 5 % Photoinitiator und 0,5 % Antihaftadditiv, welche Präpolymerzusammensetzung sich durch eine vollständige Umsetzung auszeichnet und damit hergestellte Lacke sich durch eine besonders hohe Kratzfestigkeit auszeichnen.

### Beispiel 2

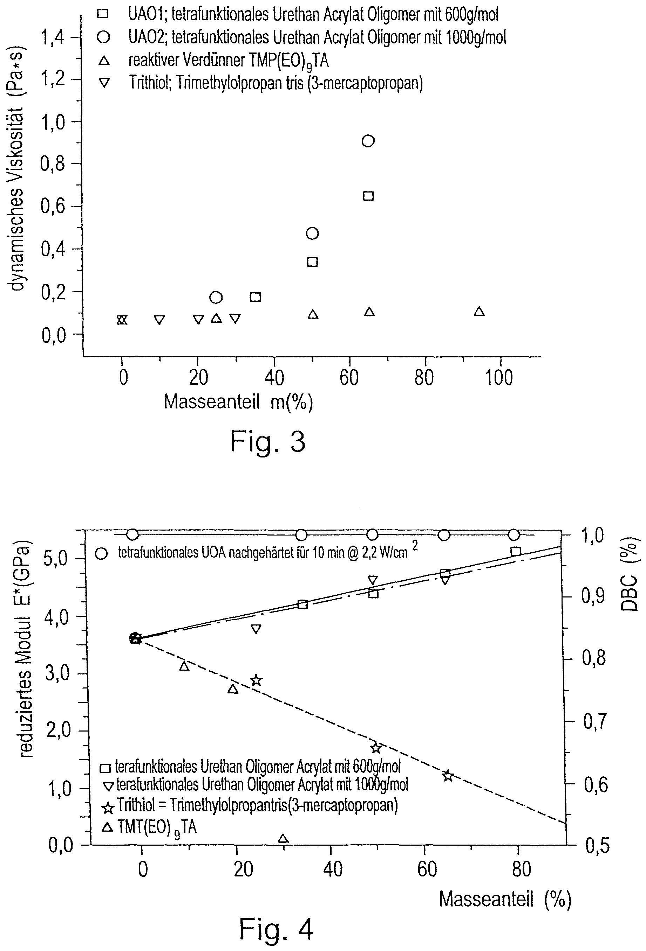

Eine Präpolymermischung bestehend aus Urethanacrylat-Oligomer, reaktivem Verdünner, Photoinitiator, multifunktionalem Monomerbaustein mit wenigstens zwei Thiolgruppen, insbesondere Trithiol sowie Photoinitiator wurde in Bezug auf die Änderung der Viskosität untersucht, indem der Einfluss der Kettenlänge des Oligomerbausteins mit wenigstens einer polymerisierbaren Doppelbindung auf die Viskosität, die Konzentration des Monomerbausteins mit wenigstens zwei Thiolgruppen auf die Viskosität, sowie des reaktiven Verdünners auf die Viskosität untersucht. Wie dies aus Fig. 3 ersehen werden kann, steigt die dynamische Viskosität in Abhängigkeit von der Kettenlänge des Oligomerbausteins mit wenigstens zwei polymerisierbaren Doppelbindung. Aus diesem Versuch kann ersehen werden, dass je höher der Anteil des Oligomerbausteins ist, desto höher ist die Viskosität des Präpolymersystems. Da es für ein Rolle-zu-Rolle Verfahren günstig ist, wenn die Präpolymerzusammensetzung eine dynamische Viskosität von unter 1,0 Pas aufweist, und es hat sich in weiteren Versuchen herausgestellt, dass bei Verwendung von derartigen Präpolymerzusammensetzungen glatte, gleichmäßig dicke Schichten erreicht werden können. Selbstverständlich ist, dass je geringer die Viskosität des Prägelacks ist, desto eher können komplizierte Strukturen des Prägereliefs in dem Stempel während einem Rolle-zu-Rolle Prägeverfahren hinreichend schnell ausgefüllt werden und in der Folge exakt übertragen werden.

Aus Fig. 3 kann ersehen werden, dass eine optimale Präpolymerzusammensetzung für einen Imprintlack bzw. ein Prägestempelmaterial einen Anteil von weniger als 60 % Urethanacrylat-Oligomer mit einem Molekulargewicht < 1000 g/mol aufweist und dass die Konzentrationen der anderen Komponenten, wie Antihaftadditiv, multifunktionaler Monomerbausteine mit wenigstens zwei Thiolgruppen, Photoinitiator und sowie die Art des reaktiven Verdünners nur einen geringen Einfluss auf die Viskosität besitzen.

Beispiel 3 zeigt, wie sich die mechanische Festigkeit, d.h. der reduzierte Young'sche Modul E* des tetrafunktionalen UAO mit 600 g/mol nach Belichtung, d.h. Vernetzung mit durch 1 min. Vorhärten bei 5 mW/cm² mit der Waldmann UV-Quelle und Endhärtung für 1 min. bei 2,2 W/cm² abhängig von der Zusammensetzung verändert.

Wie dies aus Fig. 4 ersehen werden kann, ergibt sich eine Zunahme des Elastizitätsmoduls, bei Zunahme des Anteils an Oligomerbaustein mit wenigstens einer polymerisierbaren Doppelbindung, wie z.B. einem tetrafunktionalen Urethanacrylat-Oligomer mit verschiedenen Molekulargewichten zwischen 600 g/mol bis 1000 g/mol, in einer Präpolymermatrix aus (96,5-x)%TMP(EO)₃TA, wobei x die Menge an Oligomerbausteinen mit wenigstens einer polymerisierbaren Doppelbindung bzw. TMP(EO)₉TA oder Trithiol ist, sowie 3 % 2-Hydroxy-2-methyl-1-phenyl-propan-1-on als Photoinitiator und 0,5 % Polydimethylsiloxan-Acrylat als Antihaftadditiv eingesetzt werden. Die maximalen E* Werte liegen bei 5 GPa bei einer Konzentration von 80 % Urethanacrylat-Oligomer, wobei sich die Zunahme des E-Moduls aus der Tatsache ergibt, dass die Oligomere eine höhere Anzahl an vernetzbaren Acrylatgruppen besitzen.

Tabelle 1: In gleicher Weise zeigt sich, dass der E-Modul des gehärteten Polymers abnimmt, wenn die Seitenarmlänge - d.h. die Anzahl der Ethoxy-Gruppen - der als reaktive Verdünner eingesetzten Monomerbausteine mit wenigstens einer polymerisierbaren Doppelbindung gewählt aus TMPTA, TMP(EO)₃TA, TMP(EO₆)TA, TMP(EO₉)TA zunimmt, wie dies der nachfolgenden Tabelle entnehmbar ist. Dieser Tabelle ist weiterhin entnehmbar, dass, je höher das Molekulargewicht - d.h. die Seitenarmlänge - bzw. Anzahl der Ethoxy-Gruppen - des reaktiven Verdünners ist, desto größer ist der Umsetzungsgrad der Doppelbindungen, wobei der Verdünner jeweils in einer Menge von 65 % der Gesamtpräpolymerzusammensetzung eingebracht wurde. Das Härten des Polymers wurde für 1 min bei 5 mW/cm² vorgenommen.

**Tabelle 1**

| 100 % | **DBC(%)** | **E*[MPa]** |
|---|---|---|
| TMPTA | 61 | 1701 |
| TMP(EO)₃TA | 77 | 1340 |
| TMP(EO)₆TA | 94 | 404 |
| TMP(EO)₉TA | 98 | 129 |

Als Ergebnis des Versuchs von Beispiel 3 ergibt sich eine Abnahme des E-Moduls bei Zugabe von Trithiol, was im Wesentlichen mit der Erniedrigung der Glasübergangstemperatur bei der Thiolen-Polymerisation - Zugabe von Trithiol - zusammenhängt.

Als ideale Zusammensetzung eines Präpolymers für einen Prägestempel mit großer Härte und 100 % Umsatz durch Nachhärtung ergibt sich somit: 5 % Trithiol, 35≤x≤60% UOA, (89,5-x)% TMP(EO)₃xTA, 5 % Photoinitiator und 0,5 % Antihaftadditiv. Für die Herstellung des Prägestempels ist eine schnelle Vernetzung nicht so notwendig, da hier wesentlich langsamer geprägt werden kann und außerdem eine Nachhärtung möglich ist.

Eine zweite ideale Zusammensetzung für den Imprintlack mit nahezu vollständigem Umsatz wäre: 5 % Trithiol, 35≤x≤60% UAO, (89,5-x)% TMP(EO)₉TA, 5 % Photoinitiator und 0,5 % Antihaftadditiv, wobei keine Nachhärtung notwendig ist.

Beispiel 4 zeigt den Einfluss der Menge eines Antihaftadditivs auf die Oberflächenenergie des Präpolymers.

Wie dies aus Fig. 5 ersehen werden kann, kann durch Zusatz eines Perfluorpolyether-Acrylats (HFPO-A) als Antihaftadditiv von Konzentrationen, die unter 1 % liegen, die Oberflächenenergie des Präpolymers bei seiner Aushärtung gegen Luft/Argon extrem stark herabgesetzt werden. Demgegenüber ist ersichtlich, dass, wenn die Aushärtung des Präpolymers gegenüber einer unbehandelten Nickeloberfläche erfolgt, die hohe Oberflächenenergie des Nickels in den Lack "kopiert" wird und trotz Zusatz eines Antihaftadditivs keine wesentliche Erniedrigung der Oberflächenenergie des geprägten Polymers erreicht wird. Wenn die Aushärtung demgegenüber während der Prägung gegenüber einer mit einer selbstassemblierenden fluorierten Alkyl-Monolage behandelten Nickeloberfläche erfolgt, so wird die niedrige Oberflächenenergie dieser Monolage kopiert und es folgt wiederum eine Erniedrigung der Oberflächenenergie des geprägten, ausgehärteten Polymers, wie dies ebenfalls Fig. 5 entnehmbar ist.

Es ist somit erkenntlich, dass die Zugabe von Antihaftadditiven zu einer Präpolymerzusammensetzung, beliebiger Zusammensetzung in einer Konzentration zwischen 0,1 % und 0,5 % zu einer signifikanten Erniedrigung der Oberflächenenergie bei Aushärtung gegenüber einer niederenergetischen Oberfläche erfolgt, so dass ein defektfreies Entformen des ausgehärteten Polymers ermöglicht wird.

### Beispiel 5

Selbstreplikationen von Präpolymerzusammensetzungen basierend auf einem Mono-oder Oligomerbaustein mit wenigstens einer polymerisierbaren Doppelbindung und wenigstens einem multifunktionalen Monomerbaustein mit wenigstens zwei Thiolgruppen.

Die Präpolymerzusammensetzungen zeigen eine hervorragende Selbstreplizierbarkeit, insbesondere in einem Rolle-zu-Rolle Nanoimprintlithographieverfahren. Damit eine derartige Selbstreplizierbarkeit vorliegt, muss der Polymerstempel-Lack vollständig ausgehärtet d.h.: vollständig UMGESETZT werden. In Fig. 6 ist ein auf Urethanacrylat-Oligomer basierender Polymerstempel von einem Nickelmaster abgeformt worden (Fig. 6a) und dann von diesem eine R2R-Abformung durchgeführt worden. (Fig. 6b), woraus erkennbar ist, dass Fig. 6b ein Spiegelbild zu Fig. 6a darstellt.

In Fig. 7 ist die Replikation von nicht regelmäßigen und hinterschnittenen 3D-Strukturen dargestellt, wobei die dargestellten Figuren Kieselalgenstrukturen sind. Fig. 7a zeigt hierbei den Urethanacrylat-Master, Fig. 7b einen davon abgeformten Urethanacrylat-Oligomerprägestempel auf Folie und Fig. 7c eine mit dem Stempel von Fig. 7b mittels einem Rolle-zu-Rolle Verfahren hergestellte Prägung in einem Urethanacrylat-Oligomerprägelack gemäß der Erfindung.

In Fig. 8 ist gezeigt, dass auch die Übertragung von 3DStrukturen mit Hinterschneidungen mit einem hohen Aspektverhältnis, wie beispielsweise in Silizium geätzte Säulenstrukturen in den Urethanacrylat-Oligomerprägelack in einem Rolle-zu-Rolle Verfahren möglich ist. In Fig. 8a ist hierbei der positive Si-Master gezeigt. Von diesem Si-Master wurde ein negativer Urethanacrylat-Oligomerprägestempel hergestellt und in Fig. 8b ist die mit diesem Prägestempel in einem Rolle-zu-Rolle UV-Nanoimprintlithographieverfahren (R2R-UV-NIL) hergestellte Prägung gezeigt.

Die Figuren 6 bis 8 sind hierbei elektronenmikroskopische Aufnahmen von Linienstrukturen mit 400 nm Abstand und 600 nm Breite, die in einem R2R-Verfahren mit 10 m/min Bahngeschwindigkeit in den Urethanacrylat-Oligomerprägelack übertragen wurden.

### Beispiel 6

### Herstellung von wasser- und schmutzabweisenden Polymerfolien

Die Herstellung von wasserabweisenden und schmutzabweisenden bzw. selbstreinigenden Polymerfolien mit Präpolymerzusammensetzungen enthaltend 10 Gew.-% bis 90 Gew.-% eines Mono- oder Oligomerbausteins mit wenigstens einer polymerisierbaren Doppelbindung, insbesondere niedrigviskosen, multifunktionalen, aliphatischen Polyurethanacrylaten, 10 Gew.-% bis 90 Gew.-% eines multifunktionalen, reaktiven Verdünners gewählt aus der oben genannten Gruppe, 1 Gew.-% bis 10 Gew.-% eines Photoinitiators, insbesondere 2-Hydroxy2-methyl-1-phenyl-propan-1-on und 0,1 Gew.-% bis 3 Gew.-% eines oberflächenaktiven Antihaftpolymers, insbesondere 1H,1H, 2H,2H-Tridecafluoroctyl-Acrylat gelingt es aus der Präpolymerzusammensetzung Prägelacke herzustellen, welche eine extrem niedrige Oberflächenenergie von 12 mJ/m² aufweisen. Da das Oberflächenantihaftadditiv sehr effizient an der Lackoberfläche adsorbiert ist, bildet es eine dichte Monolage mit hohem CF₃-Anteil, wodurch es gelingt, Folien herzustellen, welche, wenn gleichzeitig ein Prägewerkzeug mit entsprechend reduzierter Oberflächenenergie eingesetzt wird, wie Nickelstempeloberflächen oder Silizium- oder Quarzoberflächen als Stempel, die jeweils mit langkettigen aktiven Perfluoralkyl-Phosphonsäuren, wie beispielsweise 1H, 1H, 2H,2H-Tridecafluoroctyl-Phosphonsäure belegt sind, ein Stempelmaterial zur Verfügung zu stellen, welches eine ebenso niedrige Oberflächenenergie von 12 mJ/m² aufweist. Um die Wasser/Polymerkontaktfläche, welche für einen wasserabweisenden bzw. schmutzabweisenden Effekt möglichst klein sein muss, weiter herabzusetzen, wird in der Folge die Lackoberfläche mikro- bzw. nanostrukturiert, wodurch der Kontaktwinkel mit Wasser auf mehr als 170° angehoben werden kann mit einer gleichzeitig sehr geringen Kontaktwinkelhysterese und der Abrollwinkel von Wassertropfen auf < 2° abgesenkt werden kann. Lediglich zum Vergleich wird festgehalten, dass glatte Oberflächen des Prägelacks einen Kontaktwinkel von etwa 115° mit Wasser aufweisen, so dass der wasserabweisende Effekt nur bei starker Neigung der Folie selbst erreicht werden kann, wohingegen bei einer strukturierten Folie Wasser auch auf einer nahezu ebenen Oberfläche nicht haften kann.

## Patentansprüche

1. Präpolymerzusammensetzung enthaltend wenigstens einen Mono- oder Oligomerbaustein mit wenigstens einer polymerisierbaren C-C Doppelbindung sowie wenigstens einen multifunktionalen Monomerbaustein, **dadurch gekennzeichnet, dass** der multifunktionale Monomerbaustein ein multifunktionaler Monomerbaustein mit wenigstens zwei Thiol-Gruppen gewählt aus der Gruppe: 3-Mercaptopropionate, 3-Mercaptoacetate, Thioglycolate und Alkylthiole, enthalten ist, dass der Mono- oder Oligomerbaustein mit wenigstens einer polymerisierbaren Doppelbindung aus der Gruppe der Acrylate, Methylacrylate, Vinylether, Allylether, Propenylether, Alkene, Diene, ungesättigte Ester, Allyl-Triazine, Allyl-Isocyanate und N-Vinylamide gewählt ist und dass wenigstens ein oberflächenaktives Antihaftadditiv gewählt aus der Gruppe Alkyl-(Meth-)Acrylate, Poly-Siloxan(Meth-)Acrylate, Perfluoralkyl-(Meth-)Acrylate, Perfluorpolyether-(Meth-)Acrylate, Alkyl-Vinylether, Poly-Siloxan-Vinylether, Perfluoralkyl-Vinylether und Perfluorpolyether-Vinylether, sowie ein Photoinitiator enthalten sind.

2. Präpolymerzusammensetzung nach Anspruch 1, **dadurch gekennzeichnet, dass** der multifunktionale Monomerbaustein mit wenigstens zwei Thiol-Gruppen in einer Menge von 1 bis 50 Gew.-%insbesondere von 5 Gew.-% bis 30 Gew.-% enthalten ist und dass zwei der wenigstens eine polymerisierbare Doppelbindung aufweisenden Mono- oder Oligomerbausteine in einer Gesamtenge von 1 Gew.-% bis 90 Gew.-%, insbesondere von 10 Gew.-% bis 50 Gew.-% enthalten sind.

3. Präpolymerzusammensetzung nach Anspruch 1 oder 2, **dadurch gekennzeichnet, dass** als Mono- oder Oligomerbaustein mit wenigstens einer polymerisierbaren Doppelbindung Urethanacrylat-Oligomere mit einem Molekulargewicht zwischen etwa 300 g/mol und 2500 g/mol einsetzt sind.

4. Präpolymerzusammensetzung nach Anspruch 3, **dadurch gekennzeichnet, dass** die Mono- oder Oligomerbausteine mit wenigstens einer polymerisierbaren Doppelbindung aus der Gruppe bifunktionale Urethanacrylat-Oligomere mit einem Molekulargewicht zwischen 300 g/mol und 1200 g/mol, trifunktionale Urethanacrylat-Oligomere mit einem Molekulargewicht zwischen 450 g/mol und 1750 g/mol und tetrafunktionale Urethanacrylat-Oligomere mit einem Molekulargewicht zwischen etwa 500 g/mol und 2500 g/mol gewählt sind.

5. Präpolymerzusammensetzung nach Anspruch 1, 2 oder 3 **dadurch gekennzeichnet, dass** das oberflächenaktive Antihaftadditiv in einer Menge von 0,01 Gew.-% bis 10 Gew.-%, insbesondere 0,1 Gew.-% bis 3 Gew.-% enthalten ist.

6. Präpolymerzusammensetzung nach einem der Ansprüche 1 bis 5, **dadurch gekennzeichnet, dass** der Photoinitiator aus der Gruppe der Thioxanthone, Ketosulphone, (Alkyl-)Benzoyl-Phenyl-Phosphinoxide, 1-Hydroxyalkylphenylketone oder 2,2-Dimethoxy-1,2-diphenylethan-1-on gewählt ist.

7. Präpolymerzusammensetzung nach Anspruch 6, **dadurch gekennzeichnet, dass** der Photoinitiator in einer Menge von 0,1 Gew.-% bis 10 Gew.-%, insbesondere 0,5 Gew.-% bis 5 Gew.-% enthalten ist.

8. Präpolymerzusammensetzung nach einem der Ansprüche 1 bis 7, **dadurch gekennzeichnet, dass** wenigstens ein Monomerbaustein mit wenigstens einer polymerisierbaren Doppelbindung als reaktiver Verdünner enthalten ist.

9. Präpolymerzusammensetzung nach Anspruch 8, **dadurch gekennzeichnet, dass** der reaktive Verdünner aus der Gruppe aliphatische (Meth-)Acrylate oder Polyether(meth-)acrylate, insbesondere HDDA oder TMP(EO)xTA gewählt ist.

10. Präpolymerzusammensetzung nach Anspruch 9, **dadurch gekennzeichnet, dass** als reaktiver Verdünner wenigstens ein multifunktionales aliphatisches oder Polyether(meth-)acrylat, insbesondere TMP(EO)₉TA, TMP(EO)6TA, TMP(EO)₃TA oder TMPTA enthalten ist.

11. Präpolymerzusammensetzung nach einem der Ansprüche 1 bis 9, **dadurch gekennzeichnet, dass** sie eine Viskosität von 0,01 Pas bis 1 Pas- aufweist.

12. Präpolymerzusammensetzung nach einem der Ansprüche 1 bis 11, **dadurch gekennzeichnet, dass** als oberflächenaktives Antihaftadditiv ein silikonhaltiges oder fluorhaltiges Additiv, gewählt aus der Gruppe der mono- oder polyfunktionellen Polydimethylsiloxan-(meth-)acrylate, Perfluor-n-alkyl-(meth-)-acrylate oder Perfluorpolyether(meth-)-acrylate in einer Menge von 0,1 Gew.-% bis 3 Gew.-% enthalten ist.

13. Verwendung der Präpolymerzusammensetzung nach einem der Ansprüche 1 bis 12 als Prägelack, wobei die gehärtete Präpolymerzusammensetzung einen E-Modul zwischen 50 MPa und 5 GPa aufweist.

14. Verwendung der Präpolymerzusammensetzung nach Anspruch 13, **dadurch gekennzeichnet, dass** der Prägelack eine Oberflächenenergie von 10 mJ/m² bis 60 mJ/m² aufweist.

15. Verwendung der Präpolymerzusammensetzung nach Anspruch 13 zur Herstellung von selbstabformungsfähigen Prägestempeln zur UV-Prägung von im Wesentlichen gleichartigen Polymeren.

16. Verwendung nach Anspruch 13, **dadurch gekennzeichnet, dass** er für eine kontinuierliche Strukturierung und in situ UV-Härtung in einem Rolle-zu-Rolle Imprintverfahren eingesetzt wird.

## Claims

1. A prepolymer composition comprising at least one mono- or oligomeric building block having at least one polymerizable C-C double bond and at least one multi-functional monomeric building block, **characterized in that** the multi-functional monomeric building block comprises a multi-functional monomeric building block having at least two thiol groups selected from the group of 3-mercaptopropionates, 3-mercaptoacetates, thioglycolates and alkylthiols, that the mono- or oligomeric building block having at least one polymerizable double bond is selected from the group of acrylates, methyl acrylates, vinyl ethers, allyl ethers, propenyl ethers, alkenes, dienes, unsaturated esters and allyl triazines, allyl isocyanates and N-vinyl amides, and that it comprises at least one surface-active anti-adhesion additive selected from the group of alkyl (meth)acrylates, poly-siloxane (meth)acrylates, perfluoroalkyl (meth)acrylates, perfluoropolyether (meth)acrylates, alkyl vinyl ethers, poly-siloxane vinyl ethers, perfluoroalkyl vinyl ethers and perfluoropolyether vinyl ethers, and a photoinitiator.

2. The prepolymer composition according to claim 1, **characterized in that** it comprises the multi-functional monomer building block having at least two thiol groups in an amount of 1 to 50 wt.%, in particular of 5 wt.% to 30 wt.%, and that it comprises two of the mono- or oligomer building blocks having at least one polymerizable double bond in a total amount of 1 wt.% to 90 wt.%, in particular of 10 wt.% to 50 wt.%.

3. The prepolymer composition according to Claim 1 or 2, **characterized in that** urethanacrylate oligomers having a molecular weight between about 300 g/mol and 2500 g/mol are used as the mono- or oligomeric building block having at least one polymerizable double bond.

4. The prepolymer composition according to claim 3, **characterized in that** the mono- or oligomeric building blocks having at least one polymerizable double bond are selected from the group of bifunctional urethane acrylate oligomers having a molecular weight between 300 g/mol and 1200 g/mol, trifunctional urethane acrylate oligomers having a molecular weight between 450 g/mol and 1750 g/mol and tetrafunctional urethane acrylate oligomers having a molecular weight between about 500 g/mol and 2500 g/mol.

5. The prepolymer composition according to claim 1, 2 or 3, **characterized in that** the surface-active anti-adhesion additive is contained in an amount of 0.01 wt.% to 10 wt.%, in particular 0.1 wt.% to 3 wt.%.

6. The prepolymer composition according to any of claims 1 to 5, **characterized in that** the photoinitiator is selected from the group of thioxanthones, ketosulphones, (alkyl-)benzoylphenylphosphine oxides, 1-hydroxyalkylphenylketones or 2,2-dimethoxy-1,2-diphenylethan-1-one.

7. The prepolymer composition according to claim 6, **characterized in that** the photoinitiator is contained in an amount of 0.1 wt.% to 10 wt.%, in particular 0.5 wt.% to 5 wt.%.

8. The prepolymer composition according to one of claims 1 to 7, **characterized in that** it contains at least one monomer building block with at least one polymerizable double bond as reactive diluent.

9. The prepolymer composition according to claim 8, **characterized in that** the reactive diluent is selected from the group of aliphatic (meth)acrylates or polyether (meth-)acrylates, in particular HDDA or TMP(EO)xTA.

10. The prepolymer composition according to claim 9, **characterized in that** at it contains least one multifunctional aliphatic or polyether (meth-)acrylate, in particular TMP(EO)₉TA, TMP(EO)6TA, TMP(EO)₃TA or TMPTA as reactive diluent.

11. The prepolymer composition according to any one of Claims 1 to 9, **characterized in that** it has a viscosity of 0.01 Pas to 1 Pas.

12. The prepolymer composition according to one of Claims 1 to 11, **characterized in that** it contains a silicone-containing or fluorine-containing additive selected from the group of mono- or polyfunctional polydimethylsiloxane (meth-)acrylates, perfluoro-n-alkyl (meth-)acrylates or perfluoropolyether (meth-)acrylates in an amount of 0.1 wt.% to 3 wt.% as a surface-active anti-adhesion additive.

13. The use of the prepolymer composition according to any of Claims 1 to 12 as an embossing lacquer, wherein the cured prepolymer composition has an elastic modulus between 50 MPa and 5 GPa.

14. The use of the prepolymer composition according to claim 13, **characterized in that** the embossed lacquer has a surface energy of 10 mJ/m2 to 60 mJ/m2.

15. The use of the prepolymer composition according to claim 13 for the manufacture of self-imprintable embossing dies for UV embossing of substantially similar polymers.

16. The use according to claim 13, **characterized in that** it is used for continuous structuring and in situ UV curing in a roll-to-roll imprint process.

## Revendications

1. Composition prépolymère contenant au moins un élément monomère ou oligomère présentant au moins une double liaison C-C polymérisable ainsi qu'au moins un élément monomère multifonctionnel, **caractérisée en ce que** l'élément monomère multifonctionnel est un élément monomère multifonctionnel comprenant au moins deux groupes thiol choisis dans le groupe comprenant: des 3-mercaptopropionates, des 3-mercaptoacétates, des thioglycolates et des alkylthiols, **en ce que** l'élément monomère ou oligomère présentant au moins une double liaison polymérisable est choisi dans le groupe comprenant les acrylates, les méthacrylates, les vinyléthers, les allyléthers, les propényléthers, les alcènes, les diènes, les esters insaturés, les allyl-triazines, les allyl-isocyanates et les N-vinyl-amides, et **en ce que** la composition contient au moins un additif anti-adhérence tensioactif choisi dans le groupe comprenant les alkyl-(méth-)acrylates, les poly-siloxane-(méth-)acrylates, les perfluoroalkyl-(méth-) acrylates, les perfluoropolyéther-(méth-)acrylates, les alkyl-vinyléthers, les poly-siloxane-vinyléthers, les perfluoroalkyl-vinyléthers, et les perfluoropolyéther-vinyléthers, ainsi qu'un photoinitiateur.

2. Composition prépolymère selon la revendication 1, **caractérisée en ce que** l'élément monomère multifonctionnel comprenant au moins deux groupes thiol est contenu en une quantité de 1 à 50 % en poids, en particulier de 5 % en poids à 30 % en poids et **en ce que** deux des éléments monomères ou oligomères présentant au moins une double liaison polymérisable sont contenus en une quantité totale de 1 % en poids à 90 % en poids, en particulier de 10 % en poids à 50 % en poids.

3. Composition prépolymère selon une revendication 1 ou 2, **caractérisée en ce que** l'on utilise comme élément monomère ou oligomère présentant au moins une double liaison polymérisable des oligomères d'uréthanacrylate présentant un poids moléculaire compris entre environ 300 g/mole et 2500 g/mole.

4. Composition prépolymère selon la revendication 3, **caractérisée en ce que** les éléments monomères ou oligomères présentant au moins une double liaison polymérisable sont choisis dans le groupe comprenant des oligomères d'uréthanacrylate bifonctionnels présentant un poids moléculaire compris entre 300 g/mole et 1200 g/mole, des oligomères d'uréthanacrylate trifonctionnels présentant un poids moléculaire compris entre 450 g/mole et 1750 g/mole et des oligomères d'uréthanacrylate tétrafonctionnels présentant un poids moléculaire compris entre environ 500 g/mole et 2500 g/mole.

5. Composition prépolymère selon une revendication 1, 2 ou 3, **caractérisée en ce que** l'additif anti-adhérence tensioactif est contenu en une quantité de 0,01 % en poids à 10 % en poids, en particulier de 0,1 % en poids à 3 % en poids.

6. Composition prépolymère selon l'une quelconque des revendications 1 à 5, **caractérisée en ce que** le photoinitiateur est choisi dans le groupe comprenant les thioxanthones, les cétosulfones, les (alkyl-)benzoylphényl-phosphinoxydes, les 1-hydroxyalkylphénylcétones ou le 2,2-diméthoxy-1,2-diphényléthane-1-one.

7. Composition prépolymère selon la revendication 6, **caractérisée en ce que** le photoinitiateur est contenu en une quantité de 0,1 % en poids à 10 % en poids, en particulier de 0,5 % en poids à 5 % en poids.

8. Composition prépolymère selon l'une quelconque des revendications 1 à 7, **caractérisée en ce qu'**au moins un élément monomère présentant au moins une double liaison polymérisable est contenu en tant que diluant réactif.

9. Composition prépolymère selon la revendication 8, **caractérisée en ce que** le diluant réactif est choisi dans le groupe comprenant des (méth-)acrylates ou des polyéther(méth-)acrylates aliphatiques, en particulier HDDA ou TMP(EO)xTA.

10. Composition prépolymère selon la revendication 9, **caractérisée en ce qu'**au moins un polyéther(méth-) acrylate aliphatique multifonctionnel, en particulier TMP(EO)₉TA, TMP(EO)6TA, TMP(EO)₃TA ou TMPTA est contenu en tant que diluant réactif.

11. Composition prépolymère selon l'une quelconque des revendications 1 à 9, **caractérisée en ce qu'**elle présente une viscosité de 0,01 Pas à 1 Pas.

12. Composition prépolymère selon l'une quelconque des revendications 1 à 11, **caractérisée en ce qu'**un additif contenant du silicone ou contenant du fluor, choisi dans le groupe des polydiméthylsiloxane-(méth-)acrylates, des perfluoro-n-alkyl-(méth-)-acrylates ou des perfluoropolyéther(méth-)-acrylates mono- ou poly-fonctionnels est contenu en une quantité de 0,1 % en poids à 3 % en poids en tant qu'additif anti-adhérence tensioactif.

13. Utilisation de la composition prépolymère selon l'une quelconque des revendications 1 à 12, comme peinture d'impression en relief, dans laquelle la composition prépolymère durcie présente un module E compris entre 50 MPa et 5 GPa.

14. Utilisation de la composition prépolymère selon la revendication 13, **caractérisée en ce que** la peinture d'impression en relief présente une énergie superficielle de 10 mJ/m² à 60 mJ/m².

15. Utilisation de la composition prépolymère selon la revendication 13 pour la fabrication de tampons d'impression en relief capables d'auto-moulage pour l'impression en relief sous UV de polymères essentiellement identiques.

16. Utilisation selon la revendication 13, **caractérisée en ce qu'**on l'utilise pour une structuration continue et un durcissement aux UV in situ dans un procédé d'impression rouleau à rouleau.
